# FASCICULE DE BREVET EUROPEEN

(11) **EP 3 276 662 B1**
(45) Date de publication et mention de la délivrance du brevet: **28.10.2020**
(21) Numéro de dépôt: 17156411.5
(22) Date de dépôt: 16.02.2017
(51) Int. Cl.: H01L 27/02, H02H 9/04

(54) **STRUCTURE DE PROTECTION D'UN CIRCUIT INTÉGRÉ CONTRE LES DÉCHARGES ÉLECTROSTATIQUES**
STRUKTUR ZUM SCHUTZ EINES INTEGRIERTEN SCHALTKREISES GEGEN ELEKTROSTATISCHE ENTLADUNGEN
STRUCTURE FOR PROTECTING AN INTEGRATED CIRCUIT AGAINST ELECTROSTATIC DISCHARGES

(30) Priorité: 26.07.2016 FR 1657160
(43) Date de publication de la demande: 31.01.2018
(73) Titulaire: STMICROELECTRONICS (ROUSSET) SAS, 13790 Rousset (FR)
(72) Inventeur: TAILLIET, François, 13710 Fuveau (FR)
(74) Mandataire: Cabinet Beaumont

(56) Documents cités:
- EP-A1- 0 490 786
- US-A- 5 548 135
- US-A1- 2005 275 984
- US-A1- 2009 278 168
- US-A1- 2016 149 021

## Description

### Domaine

La présente invention concerne la protection des circuits intégrés contre des décharges électrostatiques.

### Exposé de l'art antérieur

Un circuit intégré comprend des plots métalliques destinés à assurer des connexions vers l'extérieur. Certains des plots sont adaptés à recevoir des potentiels d'alimentation. Les autres plots sont adaptés à recevoir et/ou à fournir des signaux d'entrée-sortie. Des rails d'alimentation, reliés aux plots d'alimentation, sont généralement prévus tout autour du circuit pour alimenter ses différents composants. Généralement, une couche isolante recouvre le circuit, ne laissant accessibles que les plots métalliques.

Un tel circuit reçoit et/ou fournit généralement des signaux à faible niveau de tension (par exemple 1 à 5 V) et à faible intensité de courant (par exemple 1 µA à 10 mA), et est susceptible d'être endommagé lorsque des surtensions ou des surintensités surviennent entre des plots du circuit.

On prévoit donc d'associer à chaque plot une structure de protection. La structure de protection doit pouvoir évacuer rapidement des courants importants, susceptibles d'apparaître lorsqu'une décharge électrostatique survient entre deux plots du circuit.

Le document US 6765771 décrit un exemple de structure de protection comprenant un thyristor. Les documents US 2009/278168, US 2005/275984, et US 2016/149021 décrivent chacun un dispositif de protection contre les décharges électrostatiques. Le document EP 0 490 786 décrit un circuit de protection contre des surtensions de ligne.

### Résumé

L'invention concerne un circuit intégré protégé contre les décharges électrostatiques, tel que défini par la revendication indépendante. Des modes de réalisation préférés sont définis par les revendications dépendantes.

Ainsi, l'invention prévoit un circuit intégré protégé contre des décharges électrostatiques comprenant au moins un plot d'entrée-sortie et une borne destinée à être reliée à une source d'un potentiel de référence et comprenant, en outre, une structure de protection comprenant :
un thyristor connecté en direct entre le plot et la borne, le thyristor comportant une première résistance entre sa gâchette de cathode et la borne ; et
entre le thyristor et le plot, au moins une diode Zener, l'anode de la diode Zener étant connectée à la gâchette de cathode du thyristor et la cathode de la diode Zener étant reliée au plot par l'intermédiaire d'au moins une deuxième résistance, la jonction de la diode Zener étant distincte des jonctions de la structure PNPN du thyristor. Le circuit comprend un substrat dopé d'un premier type de conductivité et ayant une face et la structure de protection comprend, en outre, une première région semiconductrice dopée d'un second type de conductivité opposé au premier type de conductivité et s'étendant dans le substrat depuis la face, la première région comprenant une première portion s'étendant selon une première direction et se prolongeant à chaque extrémité par une deuxième portion s'étendant selon une deuxième direction perpendiculaire à la première direction, le thyristor comprenant un premier transistor et un deuxième transistor, la première portion de la première région formant la base du premier transistor et la cathode de la diode Zener étant formée dans la deuxième portion de la première région.

Selon un mode de réalisation, la structure de protection comprend, en outre, au moins une troisième résistance entre la gâchette d'anode du thyristor et le plot.

Selon un mode de réalisation, la structure de protection comprend, en outre, une diode, l'anode de la diode étant connectée à la borne et la cathode de la diode étant connectée au plot.

Selon un mode de réalisation, le circuit comprend des moyens pour commander le déclenchement du premier transistor avant, après ou en même temps que le déclenchement du deuxième transistor.

Selon un mode de réalisation, la structure de protection comprend, en outre, une deuxième région semiconductrice dopée du premier type de conductivité, plus fortement dopée que le substrat, s'étendant dans la première portion de la première région seulement sur une partie de la profondeur de la première portion de la première région, la deuxième région formant l'émetteur du premier transistor.

Selon un mode de réalisation, la structure de protection comprend, en outre, dans chaque deuxième portion de la première région, une troisième région semiconductrice dopée du premier type de conductivité, plus fortement dopée que le substrat, s'étendant dans la deuxième portion de la première région seulement sur une partie de la profondeur de la deuxième portion de la première région, la troisième région formant l'anode de la diode Zener.

Selon un mode de réalisation, la structure de protection comprend, en outre, dans chaque deuxième portion de la première région, au moins une quatrième région semiconductrice dopée du deuxième type de conductivité, s'étendant depuis la face, traversant la troisième région semiconductrice et venant au contact de la deuxième portion de la première région, la quatrième région formant la cathode de la diode Zener.

Selon un mode de réalisation, la structure de protection comprend, en outre, une cinquième région semiconductrice dopée du deuxième type de conductivité, la cinquième région étant située en profondeur dans le substrat, la première région recouvrant partiellement la cinquième région et étant au contact de la cinquième région.

Selon un mode de réalisation, la cinquième région délimite au moins une première zone du substrat recouvrant la cinquième région et formant la base du deuxième transistor.

Selon un mode de réalisation, la cinquième région forme une résistance électrique reliée à la cathode de chaque diode Zener.

Selon un mode de réalisation, la cinquième région forme un shunt relié à la base du premier transistor.

Selon un mode de réalisation, la cinquième région forme au moins en partie la cathode ou l'anode de la diode.

Selon un mode de réalisation, la structure de protection comprend, en outre, deux sixièmes régions semiconductrices dopées du deuxième type de conductivité, s'étendant dans le substrat depuis la face et venant au contact de la cinquième région, les deux sixièmes régions étant situées de part et d'autre de la première portion de la première région, chaque sixième région étant séparée des deuxièmes portions de la première région par une deuxième zone du substrat, les sixièmes régions formant la cathode de la diode.

Selon un mode de réalisation, les deuxièmes zones du substrat forment un shunt relié à la base du deuxième transistor.

Selon un mode de réalisation, la structure de protection comprend, en outre, deux septièmes régions semiconductrices dopées du deuxième type de conductivité, s'étendant dans le substrat depuis la face et ne venant pas au contact de la cinquième région ni au contact des deuxièmes portions de la première région, les deux septièmes régions étant situées de part et d'autre de la première portion de la première région, chaque septième région étant intercalée entre la première portion de la première région et l'une des sixièmes régions, les septièmes régions formant l'émetteur du deuxième transistor.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un mode de réalisation d'une structure de protection d'un circuit intégré contre les décharges électrostatiques ;
la figure 2 est une vue de dessus, partielle et schématique, de régions dopées d'un substrat semiconducteur de la structure de protection de la figure 1 et des contacts reliant ces régions dopées à des pistes métalliques du premier niveau de métallisation ;
les figures 3 et 4 sont des vues en coupe, partielles et schématiques, de la figure 2 respectivement selon les lignes III-III et IV-IV ;
la figure 5 est une vue de dessus, partielle et schématique, des pistes métalliques du premier niveau de métallisation de la structure de protection de la figure 1 et des contacts reliant ces pistes aux régions dopées du substrat ;
la figure 6 est une vue de dessus, partielle et schématique, des pistes métalliques des premier et deuxième niveaux de métallisation de la structure de protection de la figure 1 et des vias conducteurs reliant les pistes métalliques du premier niveau de métallisation aux pistes métalliques du deuxième niveau de métallisation ;
les figures 7A, 8A, 9A, 10A, 11A et 12A représentent chacune le schéma électrique de la structure de protection de la figure 1 sur lequel est indiqué le parcours emprunté par le courant à différentes phases de fonctionnement de la structure de protection de la figure 1 ; et
les figures 7B, 8B, 9B, 10B, 11B et 12B représentent chacune la caractéristique courant-tension de la structure de protection de la figure 1 dans laquelle la portion de la caractéristique au niveau de laquelle se situe le point de fonctionnement de la structure de protection à différentes phases de fonctionnement est mise en évidence.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. Dans la description qui suit, lorsque l'on fait référence à des qualificatifs de position relative, tels que les termes "dessus", "supérieur", etc., ou à des qualificatifs d'orientation, tels que les termes "horizontal", "vertical", etc., il est fait référence à l'orientation des figures ou à un circuit intégré dans une position normale d'utilisation. Sauf précision contraire, les expressions "approximativement", "sensiblement", et "de l'ordre de" signifient à 10 % près, de préférence à 5 % près.

Par ailleurs, dans la présente description, on utilise le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté") soit une liaison via un ou plusieurs composants intermédiaires (résistance, condensateur, etc.).

Selon un mode de réalisation, il est prévu pour chaque plot d'alimentation ou d'entrée/sortie d'un circuit intégré une structure de protection contre les décharges électrostatiques reliant le plot à une borne de masse. Le terme masse désigne ici et dans la suite de la description un potentiel de référence commun à divers composants du circuit intégré, par exemple un potentiel d'alimentation basse. Les connexions à la masse du circuit intégré peuvent se faire par l'intermédiaire d'un rail de masse, ou rail d'alimentation basse, ce rail étant relié à un plot, accessible à l'extérieur du circuit et adapté à être mis au potentiel de référence choisi.

Selon un mode de réalisation, la structure de protection comprend un thyristor pour l'évacuation, en cas de décharge électrostatique positive, d'un courant important du plot vers la borne de masse. Selon un mode de réalisation, les résistances de dérivation ou shunts reliées aux bases des transistors bipolaires composant le thyristor sont réalisées indépendamment l'une de l'autre et leurs valeurs peuvent être ajustées selon le fonctionnement souhaité de la structure de protection. Le circuit de commande de la gâchette du thyristor comprend au moins une diode Zener. Les shunts des bases des transistors bipolaires composant le thyristor sont de préférence formés par des régions semiconductrices dopées d'un substrat semiconducteur. Ceci permet de façon avantageuse de réduire la surface occupée par la structure de protection. Une structure de protection compacte peut ainsi être obtenue. Selon un mode de réalisation, la structure de protection comprend en outre une diode pour l'évacuation, en cas de décharge électrostatique négative, d'un courant entre le plot et la borne de masse.

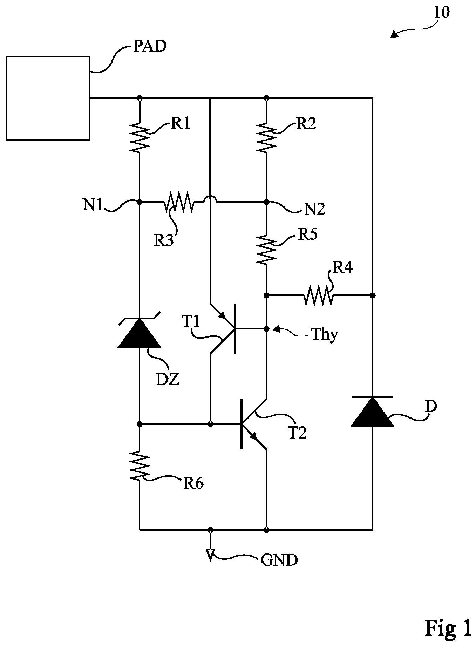

La figure 1 représente un schéma électrique équivalent d'un mode de réalisation d'une structure de protection 10 contre les décharges électrostatiques. La figure 1 représente un plot d'entrée-sortie PAD d'un circuit intégré. Le plot d'entrée-sortie PAD est couplé à la structure de protection 10 connectée entre ce plot PAD et une borne de masse GND du circuit.

La structure de protection 10 comprend un thyristor Thy, connecté en direct entre le plot d'entrée-sortie PAD et la masse GND. En figure 1, le thyristor Thy est représenté par un transistor bipolaire T1 de type PNP et un transistor bipolaire T2 de type NPN, la base du transistor bipolaire T1 étant reliée au collecteur du transistor bipolaire T2 et la base du transistor bipolaire T2, qui correspond à la gâchette de cathode du thyristor, étant reliée au collecteur du transistor bipolaire T1. L'émetteur du transistor bipolaire PNP T1 est connecté au plot PAD et l'émetteur du transistor bipolaire NPN T2 est connecté à la masse GND.

La structure de protection 10 comprend en outre :
une résistance R1 reliant, de préférence connectant, le plot PAD à un noeud N1 ;
une résistance R2 reliant, de préférence connectant, le plot PAD à un noeud N2 ;
une résistance R3 reliant, de préférence connectant, le noeud N1 au noeud N2 ;
une diode Zener DZ ou des diodes Zener DZ montées en parallèle (une seule diode Zener étant représentée en figure 1) l'anode de chaque diode Zener étant reliée, de préférence connectée, à la base du transistor bipolaire NPN T2 et la cathode de chaque diode Zener étant reliée, de préférence connectée, au noeud N1 ;
une résistance R4 reliant, de préférence connectant, la base du transistor bipolaire PNP T1 au plot PAD ;
une résistance R5 reliant, de préférence connectant, la base du transistor bipolaire PNP T1 au noeud N2 ;
une diode D dont l'anode est reliée, de préférence connectée, à la masse GND et dont la cathode est reliée, de préférence connectée, au plot PAD ; et
une résistance R6 reliant, de préférence connectant, les anodes de chaque diode Zener DZ à la masse GND.

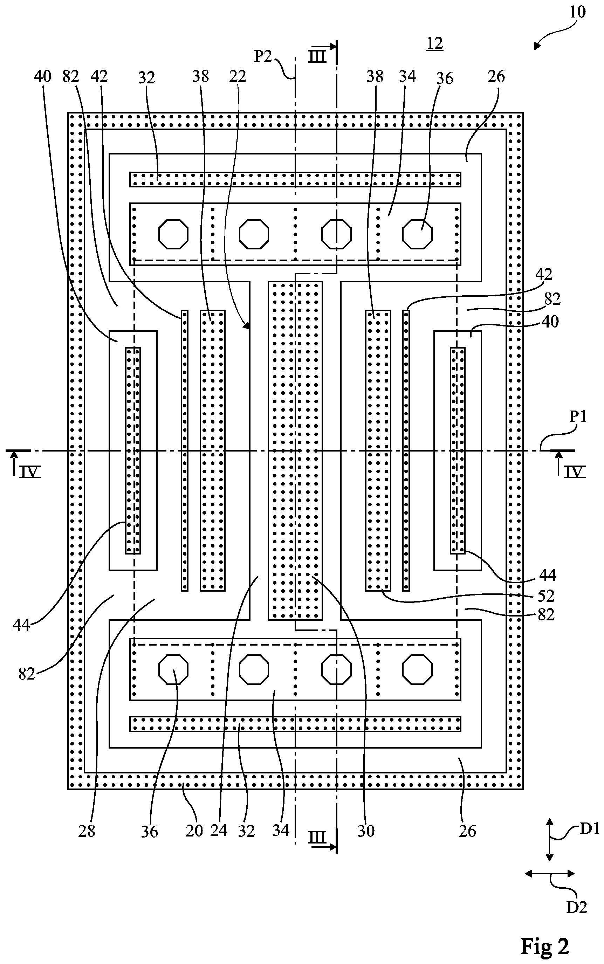

Les figures 2 à 6 illustrent un mode de réalisation de façon intégrée de la structure de protection 10 représentée en figure 1.

La structure de protection 10 comprend des régions dopées formées dans un substrat semiconducteur 12, par exemple en silicium monocristallin, dopé d'un premier type de conductivité, par exemple dopée de type P, et comprenant une face supérieure 14 sur laquelle repose un empilement de couches isolantes 16 dans lesquelles et sur lesquelles sont formées des pistes conductrices électriquement de différents niveaux de métallisation, des contacts conducteurs électriquement et des vias conducteurs électriquement.

La structure de protection 10 comprend plusieurs régions semiconductrices dopées formées dans le substrat 12. Selon un mode de réalisation, ces régions sont disposées de façon sensiblement symétrique par rapport à deux plans de symétrie perpendiculaires P1 et P2. Dans la suite de la description, on appelle D1 une direction perpendiculaire au plan P1 et on appelle D2 une direction perpendiculaire au plan P2.

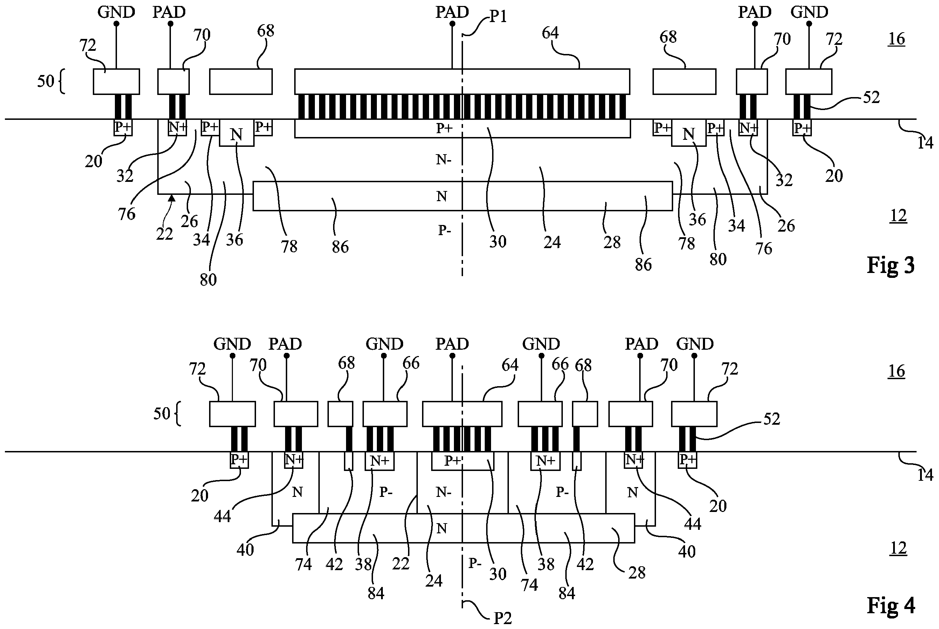

La figure 2 est une vue de dessus de la face 14 du substrat 12 et les figures 3 et 4 sont des vues en coupe de la figure 2 respectivement selon les lignes III-III et IV-IV.

Comme cela apparaît sur ces figures, la structure de protection 10 comprend :
une région 20 dopée de type P, plus fortement dopée (P+) que le substrat 12 (P-), s'étendant dans le substrat 12 depuis la face 14 et formant en vue de dessus un anneau, par exemple de forme rectangulaire, délimitant une portion de la face 14 ;
une région 22 dopée de type N, faiblement dopée (N-) s'étendant dans le substrat 12 depuis la face 14 à l'intérieur de la région annulaire 20 et ayant par exemple en vue de dessus une forme de "H", les plans P1 et P2 étant chacun un plan de symétrie de la région 22, la région 22 comprenant une portion centrale 24, ayant en vue de dessus une forme par exemple rectangulaire dont le grand axe est parallèle à la direction D1, les plans P1 et P2 étant chacun un plan de symétrie de la portion centrale 24, la portion centrale 24 se prolongeant aux extrémités par deux portions 26 latérales, ayant chacune en vue de dessus une forme par exemple rectangulaire dont le grand axe est parallèle à la direction D2, les portions latérales 26 étant disposées de façon symétrique l'une de l'autre par rapport au plan P1, le plan P2 étant un plan de symétrie pour chaque portion latérale 26 ;
une région 28, dont le bord latéral est représenté en traits pointillés en figure 2, dopée de type N, plus fortement dopée que la région 22 et formée en profondeur dans le substrat 12, en contact avec le fond de la région 22 et ayant en vue de dessus une forme par exemple rectangulaire dont le grand axe est parallèle à la direction D1, les plans P1 et P2 étant chacun un plan de symétrie de la région 28 ;
une région 30 dopée de type P, plus fortement dopée (P+) que le substrat 12, s'étendant dans le substrat 12 depuis la face 14 à l'intérieur de la région annulaire 20 et ayant par exemple en vue de dessus une forme rectangulaire, les plans P1 et P2 étant chacun un plan de symétrie de la région 30, le grand axe de la région 30 étant sensiblement parallèle à la direction D1 ;
deux régions 32 dopées de type N, fortement dopées (N+), s'étendant chacune dans l'une des portions latérales 26 de la région 22 et ayant chacune par exemple en vue de dessus une forme de bande rectiligne, les deux régions 32 s'étendant parallèlement l'une à l'autre et étant disposées de façon symétrique l'une de l'autre par rapport au plan P1, le plan P2 étant un plan de symétrie pour chaque région 32, le grand axe de chaque région 32 étant sensiblement parallèle à la direction D2 ;
deux régions 34 dopées de type P, fortement dopées (P+) s'étendant chacune dans l'une des portions latérales 26 de la région 22 et ayant chacune par exemple en vue de dessus une forme de rectangle, les deux régions 34 s'étendant parallèlement l'une à l'autre et étant disposées de façon symétrique l'une de l'autre par rapport au plan P1, le plan P2 étant un plan de symétrie pour chaque région 34, le grand axe de chaque région 34 étant sensiblement parallèle à la direction D2, chaque région 34 étant interposée entre l'une des bandes 32 et la région 30 ;
des régions 36 dopées de type N, plus fortement dopées (N+) que la région 22 et formant des îlots distincts, s'étendant dans le substrat 12 depuis la face 14 dans les régions 34, sur une profondeur supérieure à la profondeur des régions 34, de sorte que le fond de chaque région 36 est en contact électrique avec l'une des portions latérales 24 de la région 22, chaque région 36 ayant en vue de dessus par exemple une forme de disque ou de polygone, notamment d'octogone, les régions 36 étant disposées de façon symétrique par rapport aux plans P1 et P2, huit régions 36 étant représentées à titre d'exemple en figure 2, quatre régions 36 étant situées dans l'une des régions 34 et quatre régions 36 étant situées dans l'autre région 34 ;
deux régions 38 dopées de type N s'étendant dans le substrat 12 depuis la face 14 à l'intérieur de la région annulaire 20 et ayant chacune par exemple en vue de dessus une forme de bande rectiligne, les deux régions 38 s'étendant parallèlement l'une à l'autre et étant disposées de façon symétrique l'une de l'autre par rapport au plan P2, le plan P1 étant un plan de symétrie pour chaque région 38, le grand axe de chaque région 38 étant sensiblement parallèle à la direction D1, les régions 38 étant situées de part et d'autre de la portion centrale 24 de la région 22 ;
deux régions 40 dopées de type N s'étendant dans le substrat 12 jusqu'à atteindre la région enterrée 28 depuis la face 14 à l'intérieur de la région annulaire 20 et ayant chacune par exemple en vue de dessus une forme de rectangle, les deux régions 40 s'étendant parallèlement l'une à l'autre et étant disposées de façon symétrique l'une de l'autre par rapport au plan P2, le plan P1 étant un plan de symétrie pour chaque région 40, le grand axe de chaque région 40 étant sensiblement parallèle à la direction D1, les régions 40 étant situées de part et d'autre de la portion centrale 24 de la région 22, chaque région 38 étant située entre l'une des régions 40 et la portion centrale 24 de la région 22, les régions dopées de type N ne sont pas en contact avec les portions latérales 26 de la région 22 dopée de type N ;
deux régions 42 dopées de type P, plus fortement dopées (P+) que le substrat 12, s'étendant dans le substrat 12 depuis la face 14 à l'intérieur de la région annulaire 20 et ayant chacune par exemple en vue de dessus une forme d'une bande rectiligne, les deux régions 42 s'étendant parallèlement l'une à l'autre et étant disposées de façon symétrique l'une de l'autre par rapport au plan P2, le plan P1 étant un plan de symétrie pour chaque région 42, le grand axe de chaque région 42 étant sensiblement parallèle à la direction D1, les régions 42 étant situées de part et d'autre de la portion centrale 24 de la région 22, chaque région 42 étant située entre l'une des régions 40 et l'une des régions 38 ; et
deux régions 44 dopées de type N, plus fortement dopées (N+) que les régions 40, chaque région 44 s'étendant dans l'une des régions 40, les deux régions 44 s'étendant parallèlement l'une à l'autre et étant disposées de façon symétrique l'une de l'autre par rapport au plan P2, le plan P1 étant un plan de symétrie pour chaque région 44, le grand axe de chaque région 44 étant sensiblement parallèle à la direction D1.

La structure de protection 10 comprend, en outre, des régions en un matériau isolant électriquement, non représentées en figures 3 et 4, formées en surface du substrat 12 et séparant latéralement les régions 20, 30, 32, 34, 38, 44, 42 fortement dopées de type N et P. Ces régions en un matériau isolant électriquement, qui correspondent par exemple à des tranchées d'isolation électrique du type STI (sigle anglais pour Shallow Trench Isolation) s'étendent en relief depuis la face 14 et en profondeur depuis la face 14 dans le substrat 12 et dans les régions 22 et 40 dopées de type N entre les régions 20, 30, 32, 34, 38, 44, 42 fortement dopées de type N et P.

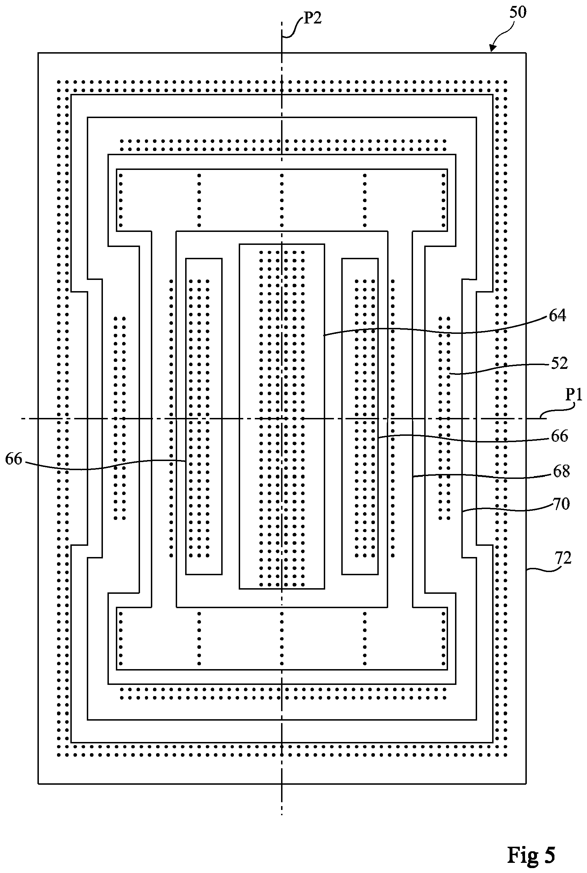

La figure 5 est une vue de dessus représentant les pistes conductrices 50 du premier niveau de métallisation de la structure de protection 10. Sur les figures 2 et 5, on a en outre représenté par des carrés noirs des contacts 52 conducteurs électriquement qui réalisent la connexion électrique entre les régions dopées de la structure de protection 10 formées dans le substrat 12 et des pistes conductrices 50 du premier niveau de métallisation. Les pistes conductrices 50 du premier niveau de métallisation et les contacts 52 sont également représentés sur les figures 3 et 4.

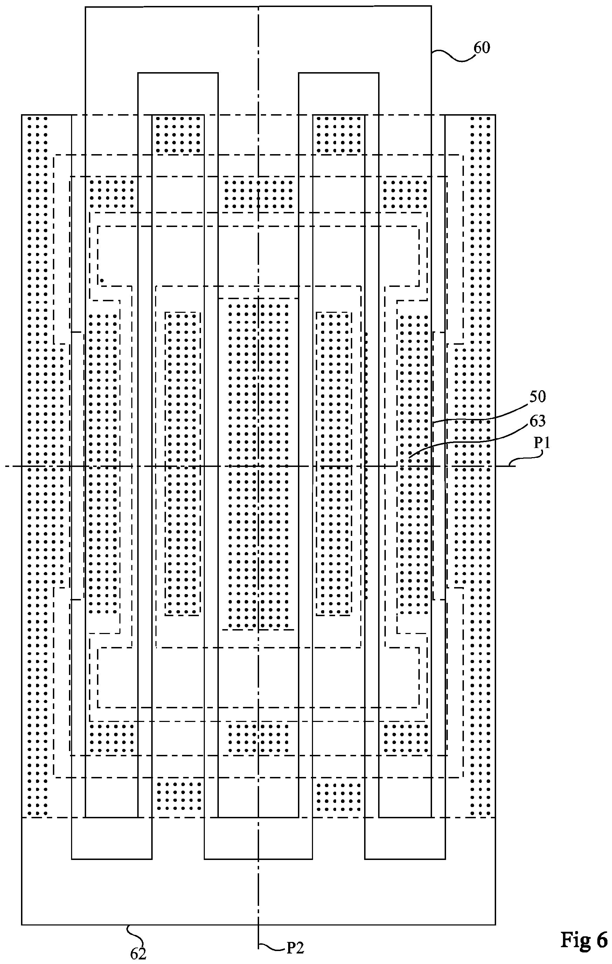

La figure 6 est une vue de dessus représentant en traits pleins deux pistes 60, 62 conductrices électriquement de la structure de protection 10 du deuxième niveau de métallisation et en traits mixtes les pistes conductrices 50 du premier niveau de métallisation. La piste conductrice 60 est connectée au plot PAD et la piste conductrice 62 est connectée à la masse GND. La piste conductrice 60 a la forme générale d'un peigne à trois dents et la piste conductrice 62 a la forme générale d'un peigne à quatre dents, les trois dents de la piste conductrice 60 étant intercalées entre les quatre dents de la piste conductrice 62. En figure 6, on a en outre représenté par des carrés noirs des vias 63 conducteurs électriquement qui réalisent la connexion électrique entre les pistes conductrices 50 du premier niveau de métallisation et les pistes conductrices 60, 62 du deuxième niveau de métallisation.

Les pistes conductrices 50 du premier niveau de métallisation sont disposées de façon sensiblement symétrique par rapport aux plans de symétrie P1 et P2. Parmi les pistes conductrices 50, on distingue :
une piste conductrice centrale 64 reliée à la région 30 et à la piste conductrice 60 ;
des pistes conductrices 66 reliées aux régions 38 et reliées à la piste conductrice 62 ;
une piste conductrice 68 de forme annulaire entourant les pistes conductrices 64 et 66, et reliée aux régions 42 et 34 ;
une piste conductrice 70 de forme annulaire entourant la piste conductrice 68, reliée aux régions 32 et 40 et reliée à la piste conductrice 60 ; et
une piste conductrice 72 de forme annulaire entourant la piste conductrice 70, reliée à la région 20 et reliée à la piste conductrice 62.

Le substrat 12 faiblement dopé de type P peut correspondre à une couche formée par épitaxie sur un support et ayant une épaisseur de 4 µm à 8 µm. Il participe notamment au fonctionnement de la diode D qui est polarisée en direct lors de décharges électrostatiques négatives. La concentration de dopants de type P du substrat 12 est typiquement de l'ordre de 10¹⁵ atomes/cm³ à 10¹⁷ atomes/cm³.

Les régions 22 et 40 de type N peuvent être une région formée en utilisant les technologies de fabrication de transistors CMOS et peuvent correspondre aux caissons dopés de type N utilisés lors de la formation de transistors CMOS. La portion 24 de la région 22 forme la base du transistor PNP T1 du thyristor Thy. Les régions 22 et 40 délimitent en partie des zones 74 partiellement isolées du substrat 12 et constituent le caisson dans lequel sont formées les diodes Zener. Les régions 22 et 40 peuvent s'étendre jusqu'à une profondeur comprise entre 1 µm et 2 µm, par exemple environ 1,5 µm. La concentration de dopants de type N des régions 22 et 40 est typiquement de l'ordre de 10¹⁶ atomes/cm³ à 10¹⁷ atomes/cm³. La longueur maximale mesurée selon la direction D1 de la région 22 peut être comprise entre 10 µm et 100 µm, par exemple environ 15 µm. La longueur maximale mesurée selon la direction D2 des portions latérales 26 de la région 22 peut être comprise entre 10 µm et 100 µm, par exemple 13 µm. La longueur mesurée selon la direction D1 de la région 40 peut être comprise entre 1 µm et 50 µm, par exemple environ 10 µm. La largeur mesurée selon la direction D2 de la région 40 peut être comprise entre 1 µm et 5 µm, par exemple environ 2 µm. De façon avantageuse, les régions 22 et 40 de type N sont formées par implantation de dopants avec la même dose et la même énergie. Les conditions d'implantation peuvent être les mêmes que celles mises en oeuvre pour la fabrication de caissons de type N utilisés lors de la formation de transistors à canal P.

La région enterrée 28 de type N permet de délimiter, avec les régions 22 et 40, les zones 74 partiellement isolées du substrat 12. Elle est en contact électrique avec la région 22. La région 28 peut être formée à une profondeur moyenne de l'ordre de 1,5 µm et avoir une épaisseur de l'ordre de 0,5 µm. La concentration de dopants de type N de la région enterrée 28 est typiquement de l'ordre de 10¹⁷ atomes/cm³. La longueur mesurée selon la direction D1 de la région 28 peut être comprise entre 10 µm et 100 µm, par exemple environ 15 µm. La largeur mesurée selon la direction D2 de la région 28 peut être comprise entre 10 µm et 50 µm, par exemple environ 13 µm.

Les régions 32, 38, 44 fortement dopées de type N peuvent être formées par implantation en utilisant les technologies de fabrication des drains et des sources de transistors MOS à canal N. Les régions 38 forment l'émetteur du transistor NPN 14 du thyristor Thy et les régions 32 et 44 forment des contacts pour les régions 22 et 40 de type N. Les régions 32, 38, 44 peuvent s'étendre jusqu'à une profondeur comprise entre 0,2 µm et 0,4 µm, par exemple environ 0,3 µm. La concentration de dopants de type N des régions 32, 38, 44 est typiquement de l'ordre de 10¹⁹ atomes/cm³ à 10²⁰ atomes/cm³. La longueur mesurée selon la direction D1 de la région 38 est de l'ordre de la longueur mesurée selon la direction D1 de la portion 24 de la région 22 et peut être comprise entre 10 µm et 100 µm. La largeur mesurée selon la direction D2 de la région 38 peut être comprise entre 0,5 µm et 5 µm, par exemple environ 1 µm. La longueur mesurée selon la direction D1 de la région 44 est légèrement inférieure à la longueur mesurée selon la direction D1 de la région 38 et peut être comprise entre 5 µm et 100 µm, par exemple environ 7,6 µm. La largeur mesurée selon la direction D2 de la région 44 peut être comprise entre 0,1 µm et 1 µm, par exemple environ 0,4 µm. La longueur mesurée selon la direction D2 de la région 32 est légèrement inférieure à la longueur mesurée selon la direction D2 de la portion 26 de la région 22 et peut être comprise entre 10 µm et 100 µm, par exemple environ 13 µm. La largeur mesurée selon la direction D1 de la région 32 peut être comprise entre 0,1 µm et 1 µm. Les régions 20, 30, 34, 42 fortement dopées de type P peuvent être formées par implantation en utilisant les technologies de fabrication des drains et des sources de transistors MOS à canal P. La région 30 forme l'émetteur du transistor PNP T1 du thyristor Thy. Les régions 42 forment un contact pour la base du transistor NPN T2 du thyristor Thy. Les régions 34 forment l'anode des diodes Zener DZ. Les régions 20 forment des contacts d'anode pour la diode D. Les régions 20, 30, 34, 42 peuvent s'étendre jusqu'à une profondeur comprise entre 0,2 µm et 0,4 µm, par exemple environ 0,3 µm. La concentration de dopants de type P des régions 20, 30, 34, 42 est typiquement de l'ordre de 10¹⁹ atomes/cm³ à 10²⁰ atomes/cm³. La longueur mesurée selon la direction D1 de la région 30 est de l'ordre de la longueur mesurée selon la direction D1 de la région 38 et peut être comprise entre 10 µm et 100 µm. La largeur mesurée selon la direction D2 de la région 30 peut être comprise entre 0,1 µm et 1 µm. La longueur mesurée selon la direction D2 de la région 34 est de l'ordre de la longueur mesurée selon la direction D2 de la région 32 et peut être comprise entre 10 µm et 100 µm. La largeur mesurée selon la direction D1 de la région 34 peut être comprise entre 1 µm et 10 µm, par exemple environ 2,5 µm. La longueur mesurée selon la direction D1 de la région 42 est de l'ordre de la longueur mesurée selon la direction D1 de la région 38 et peut être comprise entre 10 µm et 50 µm. La largeur mesurée selon la direction D2 de la région 42 peut être comprise entre 0,1 µm et 1 µm. De façon avantageuse, les régions 20, 30, 34, 42 fortement dopées de type P sont formées par implantation de dopants avec la même dose et la même énergie. Les conditions d'implantation peuvent être les mêmes que celles mises en oeuvre pour la fabrication des drains et des sources de transistors MOS à canal P.

Les régions 20, 30, 32, 34, 38, 44, 42 fortement dopées de type N et P forment en outre des régions de reprise de contact et sont électriquement reliées par des contacts 52 avec les pistes métalliques 64, 66, 68, 70, 72 du premier niveau de métallisation.

Les régions 36 dopées de type N ont une concentration de dopants qui peut être différente de celles des régions 32, 38, 44 fortement dopées de type N. Elles peuvent être formées par implantation de dopants sur une profondeur supérieure à celle des régions 34 dopées de type P de façon à être en contact électrique avec la région 22 dopée de type N. Les régions 36 sont donc en continuité électrique avec les régions 26 dopées de type N. Les régions 36 dopées de type N sont en contact avec les régions 34 dopées de type P pour former les jonctions des diodes Zener. La concentration de dopants des régions 36 détermine la tension d'avalanche des diodes Zener, par exemple entre 5 V et 5,5 V. Les régions 36 peuvent s'étendre jusqu'à une profondeur de l'ordre de 0,5 µm. La concentration de dopants de type N des régions 36 est typiquement de l'ordre de 10¹⁸ atomes/cm³. Le diamètre du cercle dans lequel s'inscrit en vue de dessus la section de chaque région 36 est compris entre 1 µm et 2 µm, par exemple environ 1,4 µm.

L'émetteur du transistor PNP T1 est formé par la région 30 fortement dopée de type P. Il est connecté directement au plot PAD. La portion centrale 24 de la région 22 dopée de type N forme la base du transistor PNP T1 et le collecteur du transistor NPN T2. Elle forme en outre la gâchette d'anode du thyristor Thy. Les zones 74 du substrat 12 forment le collecteur du transistor PNP T1 et forment la base du transistor NPN T2. Elles forment en outre la gâchette de cathode du thyristor Thy. Le potentiel des zones 74 du substrat 12 est commandé par la région 42 fortement dopée de type P. L'émetteur du transistor NPN T2 est formé par la région 38 fortement dopée de type N.

La cathode de la diode D est formée par les régions 40 dopées de type N et les portions latérales 26 de la région 22 dopée de type N avec les régions fortement dopées de type N 32 et 44 formant les contacts électriques. La région enterrée 28 participe également à la formation de la cathode de la diode D. L'anode de la diode D est formée par la portion du substrat 12 voisine de la région 20 fortement dopée de type P qui joue en outre le rôle d'un anneau de garde.

L'anode des diodes Zener est formée par la région 34 dopée de type P. La cathode des diodes Zener est formée par chaque région 36 dopée de type N. Chaque région 36 est suffisamment profonde pour traverser les régions 34 en profondeur afin d'obtenir une continuité électrique avec les portions latérales 26 sous-jacentes de la région 22 dopée de type N. Le contact de cathode est formé par les régions 32 fortement dopées de type N. Les parties 76, visibles en figure 3, des portions latérales 26 qui s'étendent entre les régions 36 et les régions 32 adjacentes forment une résistance série d'accès depuis le plot PAD vers la cathode des diodes Zener DZ. Les parties 76 correspondent sensiblement à la résistance R1 en figure 1. Les parties 78, visibles en figure 3, des portions latérales 26 qui s'étendent entre chaque région 36 et la région enterrée 28 forment une résistance série d'accès de chaque diode Zener DZ vers la région enterrée 28. Les parties 78 correspondent sensiblement à la résistance R3 en figure 1. Les parties 80 des portions latérales 26 qui s'étendent sous les régions 34 forment également une résistance série d'accès vers le plot PAD. Les parties 80 correspondent sensiblement à la résistance R2 en figure 1. Les parties 76, 78 et 80 forment un pont résistif illustrant les résistances d'accès dans les portions latérales 26 de la région 22 au voisinage de chaque diode Zener. Les caractéristiques de la diode Zener peuvent de façon avantageuse être ajustées indépendamment de celles du thyristor Thy.

La structure de protection 10 comprend un shunt à la base du transistor NPN T2 réalisé par la résistance R6 entre chaque zone 74 du substrat 12 et la masse GND. Ceci est réalisé en interrompant localement les parois de type N qui entourent latéralement les zones 74 du substrat 12 de façon à obtenir un chemin électrique entre chaque zone 74 et le reste du substrat 12. Selon un mode de réalisation, il est prévu des zones 82 du substrat 12, visibles en figure 2, reliant chaque zone 74 au reste du substrat 12. Les zones 82 s'étendent entre les régions 40 dopées de type N et les portions latérales 26 de la région 22 dopée de type N. La valeur de la résistance R6 est commandée par la forme des zones 82, en particulier par le rapport entre la longueur des zones 82 mesurées selon la direction D2 qui est sensiblement égale à la largeur mesurée selon la direction D2 des zones 40 et la longueur des zones 82 mesurées selon la direction D1 qui est sensiblement égale à la distance mesurée selon la direction D1 séparant les régions 40 et les portions 26 de la région 22.

La structure de protection 10 comprend un shunt à la base du transistor PNP T1 réalisé par plusieurs chemins résistifs correspondant aux résistances R1, R2, R3, R4 et R5 entre la base du transistor PNP T1 et le plot PAD en figure 1. Un premier chemin est formé essentiellement par les parties 84, visibles en figure 4, de la région enterrée 28 qui relient la région semiconductrice 24 dopée de type N et la région semiconductrice 40 dopée de type N. Les parties 84 correspondent sensiblement à la résistance R4. Un second chemin résistif est formé d'une part par les parties 86, visibles en figure 3, de la région enterrée 28 qui relient la portion centrale 24 de la région semiconductrice 22 dopée de type N et les portions latérales 26 de la région semiconductrice 22 et d'autre part par les parties 78 et 80 des portions latérales 26 de la région 22 dopée de type N. Les parties 86 correspondent sensiblement à la résistance R5. Les parties 84 et 86 s'étendent sensiblement selon des directions perpendiculaires. Le shunt à la base du transistor PNP T1 est donc formé par des chemins résistifs ayant des structures à trois dimensions. Les valeurs des résistances R1, R2, R3, R4, R5 et R6 peuvent être chacune de l'ordre de quelques centaines d'ohms.

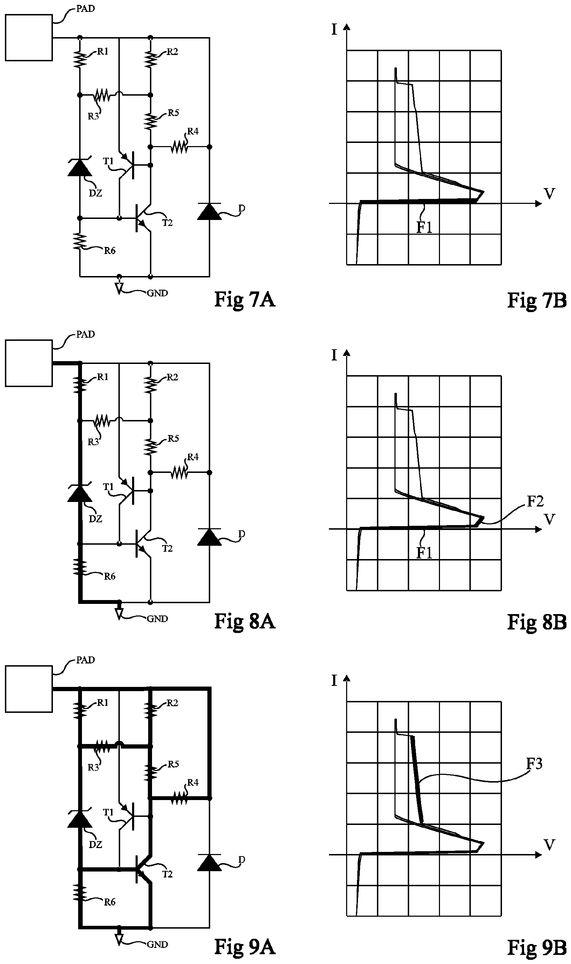

Les figures 7A, 7B, 8A, 8B, 9A, 9B, 10A, 10B, 11A, 11B, 12A et 12B illustrent le fonctionnement de la structure de protection 10. Les caractéristiques courant-tension des figures 7B, 8B, 9B, 10B, 11B et 12B ont été obtenues par des mesures électriques réelles. L'échelle sur l'axe des abscisses est de 2 V par division et l'échelle sur l'axe des ordonnées est de 10 mA par division.

La diode D fournit un chemin à faible tension vers la masse GND lors de décharges électrostatiques négatives. Le thyristor Thy fournit un chemin à faible tension vers la masse GND lors de décharges électrostatiques positives. Le rôle des diodes Zener est de commander le déclenchement du thyristor Thy. Le rôle du shunt à la base du transistor NPN T2 est de déterminer le courant de déclenchement de la gâchette de cathode du thyristor Thy et de déterminer la tension de maintien du thyristor Thy. Le rôle du shunt à la base du transistor PNP T1 est de déterminer le courant de déclenchement de la gâchette d'anode du thyristor Thy et de déterminer la tension de maintien du thyristor Thy. Les shunts à la base du transistor NPN T2 et à la base du transistor PNP T1 déterminent l'intensité du courant circulant dans les diodes Zener DZ au point de déclenchement du thyristor Thy. Les valeurs relatives des shunts à la base du transistor NPN T2 et à la base du transistor PNP T1 déterminent lequel des deux transistors T1 et T2 se déclenche en premier en régime continu. Selon un mode de réalisation, les niveaux de déclenchement des transistors T1 et T2 sont proches. Ceci permet d'atteindre une vitesse maximale de déclenchement du thyristor Thy en rendant passant sensiblement de façon simultanée les jonctions base-émetteur des transistors T1 et T2. Ceci permet d'obtenir un déclenchement plus rapide du thyristor Thy par rapport à un thyristor classique déclenché par une gâchette unique. En effet, de façon classique, le déclenchement d'un thyristor est réalisé en rendant passant le transistor NPN T2 puis en rendant passant le transistor PNP T1. La durée pour rendre conducteur le thyristor Thy est alors égale à la somme de la durée ΔT1 de la mise à l'état passant du transistor NPN T2 et de la durée ΔT2 de la mise à l'état passant du transistor PNP T1. Lorsque les niveaux de déclenchement des transistors T1 et T2 sont proches, la durée pour rendre conducteur le thyristor Thy est alors seulement égale à la durée maximale parmi les durées ΔT1 et ΔT2. La réduction de la durée de déclenchement du thyristor Thy permet de façon avantageuse d'améliorer la protection apportée par la structure de protection 10, notamment pour la protection des drains de transistors MOS à canal N. Lorsque le thyristor Thy est passant, le courant de conduction est auto-entretenu. La résistance série à l'état passant de la structure de protection 10 est faible, par exemple de l'ordre de 1 ohm et la chute de tension aux bornes de la structure de protection 10 peut être de l'ordre de 1 V.

Les figures 7A et 7B illustrent le cas où une tension positive inférieure à la tension d'avalanche de la diode Zener est appliquée entre le plot PAD et la masse GND. Aucun courant ne circule entre le plot PAD et la masse GND par la structure de protection 10. Le point de fonctionnement de la structure de protection 10 se trouve sur la partie F1 de la caractéristique courant-tension.

Les figures 8A et 8B illustrent le cas où une tension positive supérieure à la tension d'avalanche de la diode Zener est appliquée entre le plot PAD et la masse GND avec un faible courant. Le courant circule du plot PAD vers la masse en passant successivement par la résistance R1 (et éventuellement également les résistances R2, R3, R4 et R5), les diodes Zener DZ et la résistance R6. La tension aux bornes des diodes Zener DZ est sensiblement constante, par exemple d'environ 5,5 V. Le point de fonctionnement de la structure de protection 10 se trouve sur la partie F2 de la caractéristique courant-tension.

Lorsque le courant augmente à partir du cas précédent, la tension aux bornes de la résistance R1 augmente et la tension aux bornes de la résistance R6 augmente. A un premier niveau de courant In, la différence de potentiel émetteur-base du transistor NPN T2 atteint la tension de seuil, par exemple 0,6 V, du transistor T2 qui devient passant. A un deuxième niveau de courant Ip, la différence de potentiel émetteur-base du transistor PNP T1 atteint la tension de seuil, par exemple 0,6 V, du transistor T1 qui devient passant. Selon les valeurs des résistances R1 et R6, le courant In peut être inférieur strictement au courant Ip, supérieur strictement au courant Ip ou sensiblement égal au courant Ip.

Les figures 9A et 9B illustrent le cas où une tension positive supérieure à la tension d'avalanche de la diode Zener est appliquée entre le plot PAD et la masse GND, dans le cas où le courant In est inférieur strictement à Ip, et dans le cas où le courant fourni par le plot PAD devient supérieur à In. Le transistor NPN T2 devient passant. Le point de fonctionnement de la structure de protection 10 se trouve sur la partie F3 de la caractéristique courant-tension.

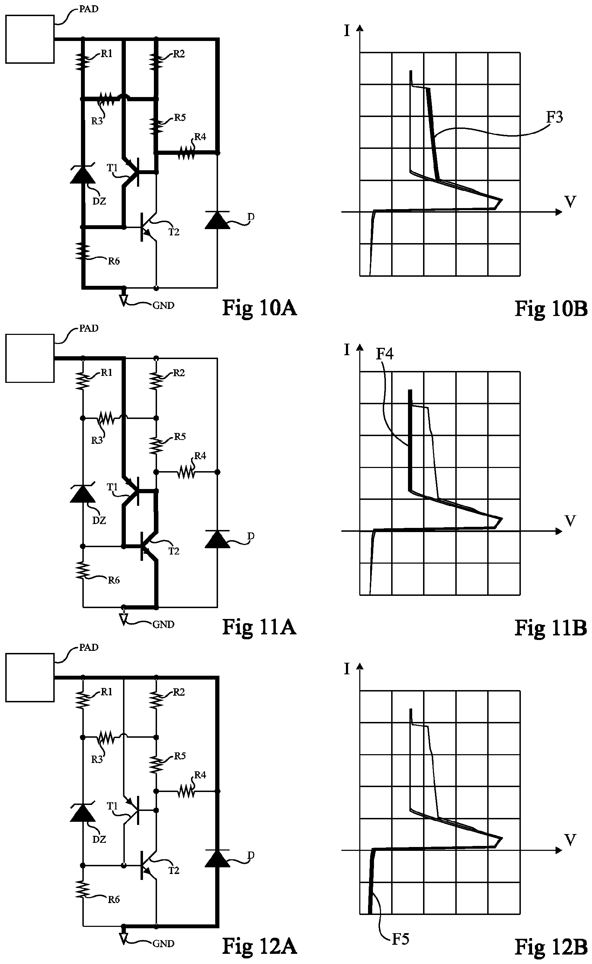

Les figures 10A et 10B illustrent le cas où une tension positive supérieure à la tension d'avalanche de la diode Zener est appliquée entre le plot PAD et la masse GND, dans le cas où le courant Ip est inférieur strictement à In, et dans le cas où le courant fourni par le plot PAD devient supérieur à Ip. Le transistor PNP T1 devient passant. Le point de fonctionnement de la structure de protection 10 se trouve sur la partie F3 de la caractéristique courant-tension.

Les figures 11A et 11B illustrent le cas où une tension positive supérieure à la tension d'avalanche de la diode Zener est appliquée entre le plot PAD et la masse GND et dans le cas où le courant fourni par le plot PAD devient supérieur à In et à Ip. Les transistors T1 et T2 sont alors passants. Le point de fonctionnement de la structure de protection 10 se trouve sur la partie F4 de la caractéristique courant-tension.

Le niveau auquel la partie F3 et la partie F4 se rejoignent en partie supérieure de la caractéristique courant-tension est déterminé notamment par les courants In et Ip. Plus la partie F3 est étendue selon l'axe des ordonnées, plus l'intensité du courant nécessaire au déclenchement du thyristor Thy est élevée. Ceci peut être avantageux pour éviter un déclenchement indésirable du thyristor Thy lors du fonctionnement normal du circuit intégré.

Les figures 12A et 12B illustrent le cas où une tension négative est appliquée entre le plot PAD et la masse GND. La diode D est polarisée en direct et conduit le courant entre la masse GND et le plot PAD. Le point de fonctionnement de la structure de protection 10 se trouve sur la partie F5 de la caractéristique courant-tension.

Des modes de réalisation particuliers ont été décrits. Diverses variantes et modifications apparaîtront à l'homme de l'art. En particulier, bien qu'un mode de réalisation ait été décrit pour un circuit intégré formé dans un substrat semiconducteur dopé de type P, il est clair que la présente invention peut être mise en oeuvre avec un substrat dopé de type N en inversant les types de dopage des régions décrites précédemment.

## Revendications

1. Circuit intégré protégé contre des décharges électrostatiques comprenant un substrat (12) dopé d'un premier type de conductivité et ayant une face (14), au moins un plot d'entrée-sortie (PAD) et une borne (GND) destinée à être reliée à une source d'un potentiel de référence et comprenant, en outre, une structure de protection (10) comprenant :
un thyristor (Thy) connecté en direct entre le plot et la borne, le thyristor comportant une première résistance (R6) entre sa gâchette de cathode et la borne ;
entre le thyristor et le plot, au moins une diode Zener (DZ), l'anode de la diode Zener étant connectée à la gâchette de cathode du thyristor et la cathode de la diode Zener étant reliée au plot par l'intermédiaire d'au moins une deuxième résistance (R1), la jonction de la diode Zener étant distincte des jonctions de la structure PNPN du thyristor ; et
une première région semiconductrice (22) dopée d'un second type de conductivité opposé au premier type de conductivité et s'étendant dans le substrat depuis la face, la première région comprenant une première portion (24) s'étendant selon une première direction (D1) parallèle à la face et se prolongeant à chaque extrémité (24) par une deuxième portion (26) s'étendant selon une deuxième direction (D2) parallèle à la face et perpendiculaire à la première direction, le thyristor (Thy) comprenant un premier transistor (T1) et un deuxième transistor (T2), la première portion de la première région formant la base du premier transistor et la cathode de la diode Zener étant formée dans la deuxième portion de la première région.

2. Circuit intégré selon la revendication 1, dans lequel la structure de protection (10) comprend, en outre, au moins une troisième résistance (R4) entre la gâchette d'anode du thyristor (Thy) et le plot (PAD).

3. Circuit intégré selon la revendication 1 ou 2, dans lequel la structure de protection (10) comprend, en outre, une diode (D), l'anode de la diode étant connectée à la borne (GND) et la cathode de la diode étant connectée au plot (PAD).

4. Circuit intégré selon l'une quelconque des revendications 1 à 3, comprenant des moyens (R4, R6) pour commander le déclenchement du premier transistor (T1) avant, après ou en même temps que le déclenchement du deuxième transistor (T1, T2).

5. Circuit intégré selon l'une quelconque des revendications 1 à 4, dans lequel la structure de protection (10) comprend, en outre, une deuxième région semiconductrice (30) dopée du premier type de conductivité, plus fortement dopée que le substrat (12), s'étendant dans la première portion (24) de la première région (22) seulement sur une partie de la profondeur de la première portion (24) de la première région (22), la deuxième région formant l'émetteur du premier transistor (T1).

6. Circuit intégré selon la revendication 5, dans lequel la structure de protection (10) comprend, en outre, dans chaque deuxième portion (26) de la première région (22), une troisième région semiconductrice (34) dopée du premier type de conductivité, plus fortement dopée que le substrat (12), s'étendant dans la deuxième portion (26) de la première région (22) seulement sur une partie de la profondeur de la deuxième portion (26) de la première région (22), la troisième région formant l'anode de la diode Zener (DZ).

7. Circuit intégré selon la revendication 6, dans lequel la structure de protection (10) comprend, en outre, dans chaque deuxième portion (26) de la première région (22), au moins une quatrième région semiconductrice (36) dopée du deuxième type de conductivité, s'étendant depuis la face (14), traversant la troisième région semiconductrice (34) et venant au contact de la deuxième portion (26) de la première région (22), la quatrième région formant la cathode de la diode Zener (DZ).

8. Circuit intégré selon l'une quelconque des revendications 1 à 7, dans lequel la structure de protection (10) comprend, en outre, une cinquième région semiconductrice (28) dopée du deuxième type de conductivité, la cinquième région étant située en profondeur dans le substrat (12), la première région recouvrant partiellement la cinquième région et étant au contact de la cinquième région.

9. Circuit intégré selon la revendication 8, dans lequel la cinquième région (28) délimite au moins une première zone (74) du substrat (12) recouvrant la cinquième région et formant la base du deuxième transistor (T2).

10. Circuit intégré selon la revendication 8 ou 9, dans lequel la cinquième région (28) forme une résistance électrique reliée à la cathode de chaque diode Zener (DZ).

11. Circuit intégré selon l'une quelconque des revendications 8 à 10, dans lequel la cinquième région (28) forme un shunt (R4) relié à la base du premier transistor (T1).

12. Circuit intégré selon la revendication 8 dans sa dépendance à la revendication 3, dans lequel la cinquième région (28) forme au moins en partie la cathode ou l'anode de la diode (D) .

13. Circuit intégré selon la revendication 8 dans son rattachement à la revendication 3, dans lequel la structure de protection (10) comprend, en outre, deux sixièmes régions semiconductrices (40) dopées du deuxième type de conductivité, s'étendant dans le substrat (12) depuis la face (14) et venant au contact de la cinquième région (28), les deux sixièmes régions étant situées de part et d'autre de la première portion (24) de la première région (22), chaque sixième région étant séparée des deuxièmes portions (26) de la première région (22) par une deuxième zone (82) du substrat (12), les sixièmes régions formant la cathode de la diode (D).

14. Circuit intégré selon la revendication 13, dans lequel les deuxièmes zones (82) du substrat (12) forment un shunt relié à la base du deuxième transistor (T2).

15. Circuit intégré selon la revendication 13 ou 14, dans lequel la structure de protection (10) comprend, en outre, deux septièmes régions semiconductrices (38) dopées du deuxième type de conductivité, s'étendant dans le substrat (12) depuis la face (14) et ne venant pas au contact de la cinquième région (28) ni au contact des deuxièmes portions (26) de la première région (22), les deux septièmes régions étant situées de part et d'autre de la première portion (24) de la première région (22), chaque septième région étant intercalée entre la première portion (24) de la première région (22) et l'une des sixièmes régions (40), les septièmes régions formant l'émetteur du deuxième transistor (T2) .

## Patentansprüche

1. Integrierte Schaltung, die gegen elektrostatische Entladungen geschützt ist, mit einem dotierten Substrat (12) eines ersten Leitfähigkeitstyps und mit einer Oberfläche (14), mindestens einem Eingangs-Ausgangs-Anschlussfeld (PAD) und einem Anschluss (GND), der mit einer Quelle eines Bezugspotentials verbunden werden kann, und ferner mit einer Schutzstruktur (10), die Folgendes aufweist:
einen Thyristor (Thy), der in Vorwärtsrichtung zwischen dem Anschlussfeld und dem Anschluss geschaltet ist, wobei der Thyristor einen ersten Widerstand (R6) zwischen seinem Kathodengate und dem Anschluss aufweist; und
zwischen dem Thyristor und dem Anschlussfeld, mindestens eine Zenerdiode (DZ), wobei die Anode der Zenerdiode mit dem Kathodengate des Thyristors verbunden ist und die Kathode der Zenerdiode über mindestens einen zweiten Widerstand (R1) mit dem Anschlussfeld verbunden ist, wobei der Übergang der Zenerdiode sich von den Übergängen der PNPN-Struktur des Thyristors unterscheidet; und
ein erstes dotiertes Halbleitergebiet (22) eines zweiten Leitfähigkeitstyps, der dem ersten Leitfähigkeitstyp entgegengesetzt ist und sich von der Oberfläche aus in das Substrat erstreckt, wobei das erste Gebiet einen ersten Abschnitt (24) aufweist, der sich entlang einer ersten Richtung (D1) parallel zu der Oberfläche erstreckt und an jedem Ende (24) durch einen zweiten Abschnitt (26) fortgesetzt wird, der sich entlang einer zweiten Richtung (D2) parallel zu der Oberfläche und senkrecht zu der ersten Richtung erstreckt, wobei der Thyristor (Thy) einen ersten Transistor (T1) und einen zweiten Transistor (T2) aufweist, wobei der erste Teil des ersten Gebiets die Basis des ersten Transistors bildet und die Kathode der Zenerdiode im zweiten Teil des ersten Gebiets ausgebildet ist.

2. Integrierte Schaltung nach Anspruch 1, wobei die Schutzstruktur (10) ferner mindestens einen dritten Widerstand (R4) zwischen dem Anodengate des Thyristors (Thy) und dem Anschlussfeld (PAD) aufweist.

3. Integrierte Schaltung nach Anspruch 1 oder 2, wobei die Schutzstruktur (10) ferner eine Diode (D) aufweist, deren Anode mit dem Anschluss (GND) verbunden ist und deren Kathode mit dem Anschlussfeld (PAD) verbunden ist.

4. Integrierte Schaltung nach einem der Ansprüche 1 bis 3, mit Mitteln (R4, R6) zum Steuern des Einschaltens des ersten Transistors (T1) vor, nach oder gleichzeitig mit dem Einschalten des zweiten Transistors (T1, T2).

5. Integrierte Schaltung nach einem der Ansprüche 1 bis 4, wobei die Schutzstruktur (10) ferner ein zweites dotiertes Halbleitergebiet (30) des ersten Leitfähigkeitstyps aufweist, das stärker dotiert ist als das Substrat (12) und sich in dem ersten Abschnitt (24) des ersten Gebiets (22) nur bis zu einem Teil der Tiefe des ersten Abschnitts (24) des ersten Gebiets (22) erstreckt, wobei das zweite Gebiet den Emitter des ersten Transistors (T1) bildet.

6. Integrierte Schaltung nach Anspruch 5, wobei die Schutzstruktur (10) ferner in jedem zweiten Abschnitt (26) des ersten Gebiets (22) ein drittes dotiertes Halbleitergebiet (34) des ersten Leitfähigkeitstyps aufweist, das stärker dotiert ist als das Substrat (12) und sich im zweiten Abschnitt (26) des ersten Gebiets (22) nur bis zu einem Teil der Tiefe des zweiten Abschnitts (26) des ersten Gebiets (22) erstreckt, wobei das dritte Gebiet die Anode der Zenerdiode (DZ) bildet.

7. Integrierte Schaltung nach Anspruch 6, wobei die Schutzstruktur (10) außerdem in jedem zweiten Teil (26) des ersten Gebiets (22) mindestens ein viertes dotiertes Halbleitergebiet (36) des zweiten Leitfähigkeitstyps aufweist, das sich von der Oberfläche (14) aus erstreckt, das dritte Halbleitergebiet (34) kreuzt oder schneidet und mit dem zweiten Teil (26) des ersten Gebiets (22) in Kontakt kommt, wobei das vierte Gebiet die Kathode der Zenerdiode (DZ) bildet.

8. Integrierte Schaltung nach einem der Ansprüche 1 bis 7, wobei die Schutzstruktur (10) ferner ein fünftes dotiertes Halbleitergebiet (28) des zweiten Leitfähigkeitstyps aufweist, wobei das fünfte Gebiet in der Tiefe im Substrat (12) angeordnet ist, und wobei das erste Gebiet das fünfte Gebiet teilweise abdeckt und mit dem fünften Gebiet in Kontakt steht.

9. Integrierte Schaltung nach Anspruch 8, wobei das fünfte Gebiet (28) mindestens einen ersten Bereich (74) des Substrats (12) abgrenzt, der das fünfte Gebiet abdeckt und die Basis des zweiten Transistors (T2) bildet.

10. Integrierte Schaltung nach Anspruch 8 oder 9, wobei das fünfte Gebiet (28) einen elektrischen Widerstand bildet, der mit der Kathode jeder Zenerdiode (DZ) verbunden ist.

11. Integrierte Schaltung nach einem der Ansprüche 8 bis 10, wobei das fünfte Gebiet (28) einen Nebenschluss (R4) bildet, der mit der Basis des ersten Transistors (T1) verbunden ist.

12. Integrierte Schaltung nach den Ansprüchen 8 und 3, wobei das fünfte Gebiet (28) zumindest teilweise die Kathode oder die Anode der Diode (D) bildet.

13. Integrierte Schaltung nach Anspruch 8 und 3, wobei die Schutzstruktur (10) ferner zwei sechste dotierte Halbleitergebiete (40) des zweiten Leitfähigkeitstyps aufweist, die sich im Substrat (12) von der Oberfläche (14) aus erstrecken und mit dem fünften Gebiet (28) in Kontakt kommen, wobei die beiden sechsten Gebiete auf beiden Seiten des ersten Abschnitts (24) des ersten Gebiets (22) angeordnet sind, wobei jedes sechste Gebiet von den zweiten Abschnitten (26) des ersten Gebiets (22) durch einen zweiten Bereich (82) des Substrats (12) getrennt ist, wobei die sechsten Gebiete die Kathode der Diode (D) bilden.

14. Integrierte Schaltung nach Anspruch 13, wobei die zweiten Bereiche (82) des Substrats (12) einen mit der Basis des zweiten Transistors (T2) verbundenen Nebenschluss bilden.

15. Integrierte Schaltung nach Anspruch 13 oder 14, wobei die Schutzstruktur (10) ferner zwei siebte dotierte Halbleitergebiete (38) des zweiten Leitfähigkeitstyps aufweist, die sich in dem Substrat (12) von der Oberfläche (14) aus erstrecken und die weder mit dem fünften Gebiet (28) noch mit den zweiten Abschnitten (26) des ersten Gebiets (22) in Kontakt kommen, wobei die beiden siebten Gebiete auf beiden Seiten des ersten Abschnittes (24) des ersten Gebiets (22) angeordnet sind, wobei jedes siebte Gebiet zwischen dem ersten Abschnitt (24) des ersten Gebiets (22) und einem der sechsten Gebiete (40) angeordnet ist, wobei die siebten Gebiete den Emitter des zweiten Transistors (T2) bilden.

## Claims

1. An integrated circuit protected against electrostatic discharges comprising a doped substrate (12) of a first conductivity type and having a surface (14), at least one input-output pad (PAD) and a terminal (GND) adapted to be connected to a source of a reference potential and further comprising a protection structure (10) comprising:
a thyristor (Thy) forward-connected between the pad and the terminal, the thyristor comprising a first resistor (R6) between its cathode gate and the terminal; and
between the thyristor and the pad, at least one Zener diode (DZ), the anode of the Zener diode being connected to the cathode gate of the thyristor and the cathode of the Zener diode being connected to the pad via at least one second resistor (R1), the junction of the Zener diode being different from the junctions of the PNPN structure of the thyristor; and
a first doped semiconductor region (22) of a second conductivity type opposite to the first conductivity type and extending in the substrate from the surface, the first region comprising a first portion (24) extending along a first direction (D1) parallel to the surface and continued at each end (24) by a second portion (26) extending along a second direction (D2) parallel to the surface and perpendicular to the first direction, the thyristor (Thy) comprising a first transistor (T1) and a second transistor (T2), the first portion of the first region forming the base of the first transistor and the cathode of the Zener diode being formed in the second portion of the first region.

2. The integrated circuit of claim 1, wherein the protection structure (10) further comprises at least a third resistor (R4) between the anode gate of the thyristor (Thy) and the pad (PAD).

3. The integrated circuit of claim 1 or 2, wherein the protection structure (10) further comprises a diode (D), the anode of the diode being connected to the terminal (GND) and the cathode of the diode being connected to the pad (PAD).

4. The integrated circuit of any of claims 1 to 3, comprising means (R4, R6) for controlling the turning on of the first transistor (T1) before, after, or at the same time as the turning on of the second transistor (T1, T2).

5. The integrated circuit of any of claims 1 to 4, wherein the protection structure (10) further comprises a second doped semiconductor region (30) of the first conductivity type, more heavily doped than the substrate (12), extending in the first portion (24) of the first region (22) only down to part of the depth of the first portion (24) of the first region (22), the second region forming the emitter of the first transistor (T1).

6. The integrated circuit of claim 5, wherein the protection structure (10) further comprises, in each second portion (26) of the first region (22), a third doped semiconductor region (34) of the first conductivity type, more heavily doped than the substrate (12), extending in the second portion (26) of the first region (22) only down to part of the depth of the second portion (26) of the first region (22), the third region forming the anode of the Zener diode (DZ).

7. The integrated circuit of claim 6, wherein the protection structure (10) further comprises, in each second portion (26) of the first region (22), at least one fourth doped semiconductor region (36) of the second conductivity type, extending from the surface (14), crossing the third semiconductor region (34) and coming into contact with the second portion (26) of the first region (22), the fourth region forming the cathode of the Zener diode (DZ).

8. The integrated circuit of any of claims 1 to 7, wherein the protection structure (10) further comprises a fifth doped semiconductor region (28) of the second conductivity type, the fifth region being located in depth in the substrate (12), the first region partially covering the fifth region and being in contact with the fifth region.

9. The integrated circuit of claim 8, wherein the fifth region (28) delimits at least one first area (74) of the substrate (12) covering the fifth region and forming the base of the second transistor (T2).

10. The integrated circuit of claim 8 or 9, wherein the fifth region (28) forms an electric resistor connected to the cathode of each Zener diode (DZ).

11. The integrated circuit of any of claims 8 to 10, wherein the fifth region (28) forms a shunt (R4) connected to the base of the first transistor (T1).

12. The integrated circuit of claim 8 and of claim 3, wherein the fifth region (28) at least partly forms the cathode or the anode of the diode (D).

13. The integrated circuit of claim 8 and of claim 3, wherein the protection structure (10) further comprises two sixths doped semiconductor regions (40) of the second conductivity type, extending in the substrate (12) from the surface (14) and coming into contact with the fifth region (28), the two sixth regions being located on either side of the first portion (24) of the first region (22), each sixth region being separated from the second portions (26) of the first region (22) by a second area (82) of the substrate (12), the sixth regions forming the cathode of the diode (D).

14. The integrated circuit of claim 13, wherein the second areas (82) of the substrate (12) form a shunt connected to the base of the second transistor (T2).

15. The integrated circuit of claim 13 or 14, wherein the protection structure (10) further comprises two seventh doped semiconductor regions (38) of the second conductivity type, extending in the substrate (12) from the surface (14) and which do not come into contact with the fifth region (28) nor into contact with the second portions (26) of the first region (22), the two seventh regions being located on either side of the first portion (24) of the first region (22), each seventh region being interposed between the first portion (24) of the first region (22) and one of the sixth regions (40), the seventh regions forming the emitter of the second transistor (T2).
